Europäisches Patentamt

European Patent Office

Office européen des brevets

(19)

(11) Veröffentlichungsnummer : **0 330 899 B1**

(12) # EUROPÄISCHE PATENTSCHRIFT

(45) Veröffentlichungstag der Patentschrift :
**15.07.92 Patentblatt 92/29**

(51) Int. Cl.⁵ : **H01L 39/24, C30B 1/02, C30B 29/22**

(21) Anmeldenummer : **89102461.4**

(22) Anmeldetag : **13.02.89**

(54) **Verfahren zur Herstellung einer Schicht aus einem metalloxidischen Supraleitermaterial mit hoher Sprungtemperatur und Vorrichtung zur Durchführung des Verfahrens.**

(30) Priorität : **26.02.88 DE 3806078**

(43) Veröffentlichungstag der Anmeldung :
**06.09.89 Patentblatt 89/36**

(45) Bekanntmachung des Hinweises auf die Patenterteilung :
**15.07.92 Patentblatt 92/29**

(84) Benannte Vertragsstaaten :
**AT DE FR GB IT NL**

(56) Entgegenhaltungen :
**EP-A- 0 295 023**
**US-A- 4 046 618**

(56) Entgegenhaltungen :
**APPLIED PHYSICAL LETTERS, Band 51, Nr. 8, 24. August 1987, Seiten 614-616, American Institute of Physics; R. BEYERS et al.:"Annealing treatment effects on structure and superconductivity in Y1Ba2Cu3O9-x"**
**PHYSICA, Band 148B, Nr. 1-3, Dezember 1987, Seiten 182-184, Elsevier Science Publishers B.V., Amsterdam, NL; R.B. LAIBOWITZet al.: "Fabrication and properties of thin superconducting oxide films"**

(73) Patentinhaber : **SIEMENS AKTIENGESELLSCHAFT**
**Wittelsbacherplatz 2**
**W-8000 München 2 (DE)**

(72) Erfinder : **Kieser, Jörg, Dr.**
**Pautzfelder Strasse 19C**
**W-8550 Forchheim (DE)**

EP 0 330 899 B1

## Beschreibung

Die Erfindung bezieht sich auf ein Verfahren zur Herstellung einer Schicht aus einem metalloxidischen Supraleitermaterial mit hoher Sprungtemperatur, bei welchem zunächst eine Schicht eines metalloxidischen Vorproduktes aus den Komponenten des Materials mit einem bezuglich der auszubildenden supraleitenden Metalloxidphase noch fehlstrukturierten Kristallgefüge auf einem Substrat aufgebracht wird und anschließend mittels einer Wärme- und Sauerstoffbehandlung die gewünschte supraleitende Metalloxidphase mit einer zumindest teilweise geordneten Kristallstruktur ausgebildet wird, wobei die Kristallstruktur anisotrop ist und eine kritische Stromdichte der Schicht verursacht, die parallel zur Oberfläche der Schicht größer als in Richtung der Normalen auf der Schicht ist. Ein derartiges Verfahren geht z.B. aus "Physical Review Letters", Vol. 8, No. 25, 22.6.1987, Seiten 2684 bis 2686 hervor. Die Erfindung betrifft ferner eine Vorrichtung zur Durchführung dieses Verfahrens.

Die ältere Europäische Patentanmeldung EP-A-0 295 023, die die Bedingungen des Artikels 54(3) EPÜ insoweit erfüllt, wie ihre Merkmale in den prioritätsbegründenden Anmeldungen vom 12.06.87 und 27.11.87 enthalten sind, offenbart insoweit ein Verfahren zur Herstellung einer Schicht aus einem metalloxidischen Supraleitermaterial mit hoher Sprungtemperatur, bei welchem zunächst eine Schicht eines metalloxidischen Vorproduktes aus den Komponenten des Materials auf ein Substrat aufgebracht wird und anschließend mittels einer Wärmebehandlung die gewünschte supraleitende Metalloxidphase mit einer zumindest teilweise geordneten Kristallstruktur ausgebildet wird, wobei die Kristallstruktur anisotrop ist und eine kritische Stromdichte der Schicht verursacht, die parallel zur Oberfläche der Schicht größer ist als in Richtung der Normalen auf der Schicht, bei welchem Verfahren das Vorprodukt durch eine Heizzone (heating zone) bewegt wird, so daß wenigstens der äußere Teil des supraleitenden Materialüberzugs geschmolzen und rasch wieder fest wird.

Supraleitende Metalloxidverbindungen mit hoher Sprungtemperatur $T_c$ von beispielsweise über 90 K sind allgemein bekannt. Diese Metalloxidverbindungen basieren insbesondere auf einem Stoffsystem Me1-Me2-Cu-O, wobei die Komponenten Me1 ein Seltenes Erdmetall einschließlich Yttrium und Me2 ein Erdalkalimetall zumindest enthalten können. Filme bzw. dünne Schichten aus diesen Metalloxidverbindungen werden vielfach mit speziellen Bedampfungs- oder Sputterprozessen hergestellt. Hierbei wird auf einem geeigneten Substrat zunächst ein polykristallines oder amorphes Vorprodukt mit den Komponenten des gewählten Stoffsystems abgeschieden, wobei im allgemeinen der Sauerstoffgehalt nicht exakt eingestellt ist. Dieses Vorprodukt wird anschließend mittels einer Wärme- und Sauerstoffbehandlung in das Material mit der gewünschten supraleitenden Phase überführt.

Die so zu erhaltenden supraleitenden Metalloxidphasen, deren Kristallstrukturen ähnlich der eines Perowskites sind, haben im Falle von $YBa_2Cu_3O_{7-x}$ mit $O < x < 0,5$ eine orthorhombische Struktur (vgl.z.B. "Europhysics Letters", Vol. 3, No. 12, 15.6.1987, Seiten 1301 bis 1307). Da die diese supraleitenden Phasen aufweisenden Materialien den Oxidkeramiken zuzurechnen sind, werden die entsprechenden Hoch-$T_c$-Supraleiter vielfach auch als oxidkeramische Supraleiter bezeichnet.

Aus der eingangs genannten Veröffentlichung "Phys.Rev.Lett." ist bekannt, einkristalline Filme des Systems $YBa_2Cu_3O_{7-x}$ auf einem einkristallinen $SrTiO_3$-Substrat mittels Epitaxie herzustellen. Hierzu werden zunächst auf das somit eine geordnete Kristallstruktur aufweisende, etwa 400°C heiße Substrat die drei metallischen Komponenten des Systems aus getrennten Verdampfungsquellen in einer Sauerstoffatmosphäre unter Einhaltung der gewünschten Stöchiometrie aufgedampft. Das so erhaltene Vorprodukt ist hinsichtlich der gewünschten supraleitenden Hoch-$T_c$-Phase jedoch noch fehlstrukturiert. Mittels einer sich daran anschließenden Wärmebehandlung bei hoher Temperatur von etwa 800° bis etwa 900°C und unter Sauerstoffzufuhr erhält man dann epitaktisch aufgewachsene einkristalline oder zumindest stark texturierte Filmschichten mit der gewünschten supraleitenden Hoch-$T_c$-Phase. Wegen der stark anisotropen Kristallstruktur dieser Phase weisen die so gewonnenen Filmschichten auch anisotrope kritische Stromdichten $J_c$ auf, wobei die kritische Stromdichte parallel zur Oberfläche der jeweiligen Schicht wesentlich größer als in Richtung der Normalen auf der Schicht ist und bei 77 K über $10^5$ A/cm$^2$ betragen kann. Die erwähnte Epitaxie wird dabei als notwendige Voraussetzung zur Erreichung solch hoher kritischer Stromdichten angesehen. Der Aufwand zur Herstellung entsprechender Schichten ist bei dem bekannten Verfahren jedoch erheblich. Außerdem ist die bei dem Hochtemperaturprozeß ablaufende Epitaxie schwierig zu kontrollieren. Häufig entstehen nämlich fehlorientierte Körner, die die supraleitenden Eigenschaften wie insbesondere die kritische Stromdichte ungünstig beeinträchtigen.

Neben der erwähnten Aufdampftechnik sind auch entsprechende Sputtertechniken bekannt, bei denen auf ein Substrat aus einem Target aufgesputtert wird, das mindestens die drei metallischen Komponenten des Stoffsystems enthält (vgl. z.B. "Appl. Phys.Lett.", Vol. 51, No. 9, 31.8.1987, Seiten 694 bis 696). Auch bei dieser Technik ist eine Sauerstoff-Beladung des Vorproduktes bei erhöhter Temperatur erforderlich.

Es zeigt sich jedoch, daß bei allen bekannten Verfahren zur Herstellung von dünnen Schichten aus dem Hoch-$T_c$-Supraleitermaterial auf speziellen Substraten höhere kritische Stromdichten (über $10^4$ A/cm$^2$) nur mit erheblichem Aufwand und auch dann nur schwer reproduzierbar zu erhalten sind.

Aufgabe der vorliegenden Erfindung ist es deshalb, das Verfahren der eingangs genannten Art dahingehend auszugestalten, daß mit ihm auf verhältnismäßig einfache Weise entsprechende Schichten mit kritischen Stromdichten in der genannten Größenordnung reproduzierbar herzustellen sind.

Diese Aufgabe wird erfindungsgemäß dadurch gelöst, daß das Vorprodukt mit einer vorbestimmten Geschwindigkeit parallel zur Oberfläche der Schicht durch eine erhitzte Zone bewegt wird, in der ein positiver, in bewegungsrichtung zu messender maximalen Temperaturgradient von mindestens 5 K/mm ausgebildet ist.

Der Erfindung liegt dabei die Erkenntnis zugrunde, daß mit einem durch die Schicht parallel zu deren Oberfläche wandernden Temperaturgradientenfeld die Ausbildung einer gewünschten anisotropen Kristallstruktur in Richtung der angestrebten Stromleitung gefördert wird. Die Folge davon ist eine entsprechend verbesserte kritische Stromdichte (Stromtragfähigkeit) in dieser Richtung. Außerdem eignen sich die erfindungsgemäßen Maßnahmen insbesondere zu einer kontinuierlichen Herstellung von langgestreckten Körpern wie z.B. Leitern, die mit einem supraleitenden Hoch-$T_c$-Material beschichtet sind.

Eine Vorrichtung zur Durchführung des erfindungsgemäßen Verfahrens ist dadurch gekennzeichnet, daß eine Heizvorrichtung vorgesehen ist, die mindestens zwei hintereinander angeordnete, räumlich voneinander getrennte Heizbereiche mit unterschiedlichen Temperaturniveaus zur Ausbildung der erhitzten Zone mit dem maximalen Temperaturgradienten von mindestens 5 K/mm zwischen den mindestens zwei Heizbereichen aufweist, wobei der in bewegungsrichtung gesehen nachgeordnete Bereich auf dem höheren Temperaturniveau liegt, und die insbesondere eine kontinuierliche Wärmebehandlung von langgestreckten Körpern wie z.B. Leitern ermöglicht, und daß eine Einrichtung zur Bewegung der Schicht des metalloxidischen Vorprodukts durch die erhitzte Zone parallel zur Oberfläche der Schicht mit der vorbestimmten Geschwindigkeit vorgesehen ist. Da der Aufwand zur Ausbildung entsprechender Heizvorrichtungen verhältnismäßig klein ist, läßt sich die angestrebte Verbesserung der kritischen Stromdichte in beschichteten Substraten entsprechend einfach erreichen.

Vorteilhafte Ausgestaltungen des erfindungsgemäßen Verfahrens bzw. der Vorrichtung zu seiner Durchführung gehen aus den Unteransprüchen hervor.

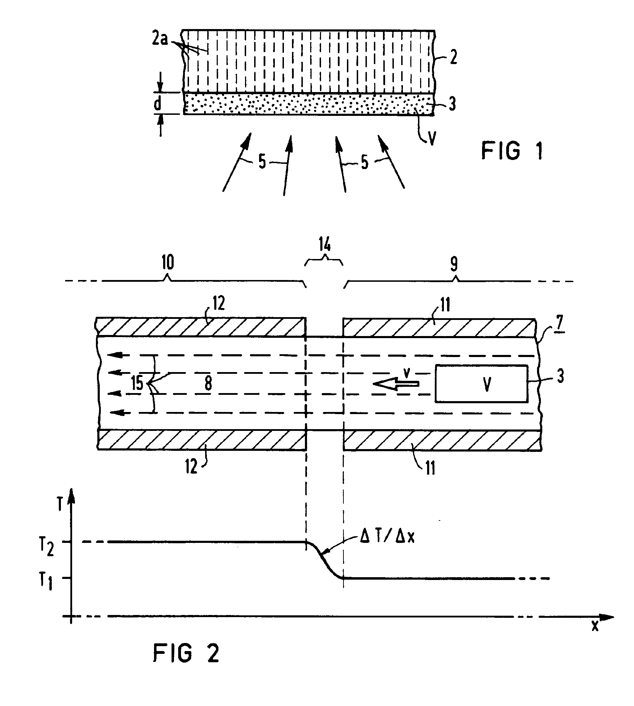

Zur weiteren Erläuterung der Erfindung wird nachfolgend auf die Zeichnung bezug genommen, in deren Figur 1 der an sich bekannte Aufbau einer Schicht angedeutet ist, die erfindungsgemäß zu behandeln ist. Figur 2 zeigt schematisch eine Vorrichtung zur Durchführung des erfindungsgemäßen Verfahrens.

Bei dem erfindungsgemäßen Verfahren wird von mindestens einer dünnen Schicht oder mindestens einem Film aus einem bekannten supraleitenden Hoch-$T_c$-Material auf einem Substrat ausgegangen. Entsprechende oxidkeramische Materialien haben eine anisotrope Kristallstruktur, die eine entsprechende Anisotropie der kritischen Stromdichte mit sich bringt. Nachfolgend wird vorausgesetzt, daß die maximale kritische Stromdichte parallel zur Oberfläche des Substrates bzw. der auf ihm abgeschiedenen Schicht zu erhalten ist. Dies kann insbesondere bei Materialien der Zusammensetzung Me1-Me2-Cu-O der Fall sein, die den weiteren Ausführungen zugrundegelegt seien. Ein entsprechendes Material sei also für die Schicht auf dem Substrat angenommen, die eine Stromtragfähigkeit in der Größenordnung von mindestens $10^4$ A/cm$^2$ bei Temperaturen in der Nähe der Sprungtemperatur $T_c$ des Materials gewährleisten soll. Als Ausgangsmaterialien der Schicht sind Me1- und Me2 insbesondere aus der Gruppe der Seltenen Erdmetalle wie z.B. Y oder La bzw. aus der Gruppe der Erdalkalimetalle wie z.B. Sr oder Ba zu wählen. Neben Y oder La für Mel geeignete Materialien sind allgemein bekannt. Dabei sollen die entsprechenden metallischen Komponenten des Systems Me1-Me2-Cu-O jeweils mindestens ein (chemisches) Element aus den genannten Gruppen enthalten oder jeweils aus diesem mindestens einem Element bestehen. D.h., Me1 und Me2 liegen vorzugsweise in elementarer Form vor. Gegebenenfalls sind jedoch auch Legierungen oder Verbindungen oder sonstige Zusammensetzungen dieser Metalle mit Substitutionsmaterialien als Ausgangsmaterialien geeignet; d.h., mindestens eines der genannten Elemente kann in bekannter Weise partiell durch ein anderes Element substituiert sein. So können z.B. die metallischen Komponenten Me1 und Me2 jeweils durch ein anderes Metall aus der Gruppe der für diese Komponenten vorgesehenen Metalle teilweise ersetzt werden. Auch das Kupfer oder der Sauerstoff des Systems können z.B. durch F partiell substituiert sein.

Neben den genannten supraleitenden Materialien sind für das erfindungsgemäße Verfahren ebensogut auch andere supraleitende Hoch-$T_c$-Werkstoffe geeignet, die eine ausgeprägte Anisotropie bzgl. ihres Kristallaufbaus und ihrer kritischen Stromdichte aufweisen. So sind z.B. aus "Superconductivity News Supplement", Vol. 1, No. 3, Febr. 1988 entsprechende Materialien auf Basis des Stoffsystems Bi-Sr-Ca-Cu-O oder aus "Journal of Low Temperature Physics", Vol. 69, Nos. 5/6, 1987, Seiten 451 bis 457 auf Basis des Stoffsystems La-Sr-Nb-O (vgl. auch "The Japan Times" vom 21.1.1988) bekannt.

Die für das Substrat zu wählenden Materialien sind vorteilhaft solche, die einen perowskit-ähnlichen Aufbau zeigen, wobei deren Einheitszellen Abmessungen aufweisen, die zumindest in etwa das Ein- oder Mehrfache der entsprechenden Abmessungen der Achsen der auf ihnen aufgewachsenen Strukturen des supraleitenden Hoch-$T_c$-Materials ausmachen. Aus diesem Grunde ist im Falle von $YBa_2Cu_3O_{7-x}$ ein einkristallines $SrTiO_3$- oder $(Ba,Sr)TiO_3$-Substrat besonders vorteilhaft. Entsprechend texturierte Substrate sind allgemein bekannt (vgl. z.B. "Izvestija Akademii Nauk SSSR", Ser.Fiz., Vol. 39, No. 5, Mai 1975, Seiten 1080 bis 1083).

Das erfindungsgemäße Verfahren ist jedoch nicht auf derartige einkristalline Substrate beschränkt. So können gegebenenfalls auch polykristalline Substrate wie z.B. polykristallines, auf einen Träger aufgedampftes $SrTiO_3$ vorgesehen werden. Neben den genannten Substratmaterialien sind ebenso auch andere bekannte Werkstoffe wie z.B. $MgO$, $Al_2O_3$, Y-stabilisiertes $ZrO_2$ oder $Ta_2O_5$ geeignet. Das Substrat kann z.B. verhältnismäßig kleinflächig und beispielsweise für eine Verwendung auf mikrotechnischem Gebiet vorgesehen sein. Insbesondere kann es sich aber auch um einen langgestreckten Körper handeln, der z.B. bandförmig gestaltet ist oder auch einen kreisförmigen oder kreisringförmigen Querschnitt aufweist und zur Herstellung von entsprechenden Leitern dient.

Als ein entsprechendes konkretes Ausführungsbeispiel sei nachfolgend anhand des in Figur 1 schematisch dargestellten Schnittes die Herstellung einer Schicht aus einem supraleitenden Material der bekannten Zusammensetzung $YBa_2Cu_3O_{7-x}$ mit orthorhombischer Struktur zugrundegelegt. Diese Schicht soll auf einem $SrTiO_3$-Substrat 2 mit geordneter Struktur, insbesondere auf einkristallinem $SrTiO_3$ ausgebildet werden. In der Figur ist die entsprechende Textur des Substrates durch gestrichelte Linien 2a angedeutet:

Auf diesem Substrat 2 wird zunächst in an sich bekannter Weise eine dünne Schicht 3 aus Y-Ba-Cu-O mit noch ungeordnetem Gefüge abgeschieden. Hierzu können die metallischen Komponenten Y, Ba, Cu des Stoffsystems z.B. in einem PVD (Physical Vapor Deposition)-Prozeß wie beispielsweise durch Aufsputtern mit Hilfe eines Magnetrons bis zu einer maximalen Schichtdicke d unter 100 µm, vorteilhaft unter 10 µm aufgebracht werden. Zur Herstellung einer Sputterschicht 3 kann ein Gleichspannungs-Niederdruckplasma in einer Ar- oder $Ar/O_2$-Atmosphäre verwendet werden. In diesem Plasma werden Ionen erzeugt, die auf eine Kathode aufprallen. Dabei zerstäuben sie das Kathodenmaterial, das aus einer Keramik des gewählten Systems Y-Ba-Cu-O besteht. In dieser Keramik sollten zumindest die drei metallischen Komponenten des Systems im stöchiometrischen Verhältnis der angestrebten supraleitenden Hoch-$T_c$-Phase vorhanden sein. Das so zerstäubte Kathodenmaterial schlägt sich dann als Neutralteilchen 5 oder als Ionen auf dem Substrat 2 nieder. Dabei kann das Substrat 2 gegebenenfalls auf einem erhöhten Temperaturniveau gehalten werden kann. Entsprechende Abscheideanlagen sind allgemein bekannt. Die einzelnen Prozeßparameter für die Abscheidung wie insbesondere der Druck und die Abscheiderate werden hierbei so eingestellt, daß auf dem Substrat allmählich eine Schicht bis zu der erwähnten Schichtdicke aufwächst. Am Ende des Abscheideprozesses liegt dann ein noch ungeordnetes Y-Ba-Cu-O-Vorprodukt V des herzustellenden supraleitenden Materials vor, das hinsichtlich der gewünschten orthorhombischen Hoch-$T_c$-Phase noch fehlstrukturiert ist. Das Vorprodukt V ist dabei im allgemeinen amorph oder polykristallin.

Abweichend von dem geschilderten Aufsputtern sind zum Abscheiden des Vorproduktes auch andere PVD-Prozesse wie z.B. reaktives, HF-unterstütztes Laser-Verdampfen oder ein Aufdampfen mit Hilfe von drei getrennten Elektronenstrahlquellen bei gleichzeitiger Zufuhr von Sauerstoff als Gas oder als Ionenstrom möglich (vgl.z.B. die eingangs genannte Veröffentlichung "Phys. Rev.Lett." 8, 25). Ebenso sind statt der physikalischen Prozesse zum Abscheiden der Schicht des noch ungeordneten Vorproduktes auch chemische Verfahren wie z.B. CVD (Chemical Vapor Deposition) geeignet.

Das so hergestellte Vorprodukt muß nun einer stets erforderlichen Wärme(Glüh)- und Sauerstoffbehandlung unterzogen werden. Dazu wird es gemäß der Erfindung durch eine erhitzte, d.h. bereits auf erhöhtem Temperaturniveau befindliche Zone bewegt, in der ein vorbestimmter Temperaturgradient ausgebildet ist. Hierfür kann vorteilhaft die in Figur 2 angedeutete Heizvorrichtung dienen, mit der insbesondere eine kontinuierliche Wärmebehandlung von langgestreckten Körpern wie z.B. Leitern möglich ist. Diese allgemein mit 7 bezeichnete Vorrichtung umfaßt einen beispielsweise rohrförmigen Arbeitsbereich 8, durch den das Vorprodukt V bzw. das mit diesem Vorprodukt beschichtete Substrat 3 mit einer vorbestimmten Geschwindigkeit v hindurchzuführen ist. Die Bewegungsrichtung soll dabei parallel zur Oberfläche des Substrates 3 bzw. des Vorproduktes V liegen. Der Arbeitsbereich weist mindestens zwei in Bewegungsrichtung gesehen hintereinanderliegende Heizbereiche 9 und 10 auf, die auf unterschiedlichen Temperaturniveaus $T_1$ und $T_2$ liegen. Dabei soll sich der in Bewegungsrichtung nachgeordnete Bereich 10 auf dem höheren Temperaturniveau $T_2$ befinden. Der Temperaturunterschied zwischen den beiden Heizbereichen 9 und 10 sollte dabei mindestens 200°C betragen. Im Falle des gewählten Y-Ba-Cu-O-Materials liegt vorteilhaft das Temperaturniveau $T_1$ des ersten Heizbereiches 9 zwischen 350°C und 550°C, vorzugsweise zwischen 400°C und 500°C, während der nachgeordnete Heizbereich 10 auf einem Temperaturniveau $T_2$ über 650°C, vorzugsweise über 750°C, z.B. zwischen 900°C und 950°C gehalten wird. Diese Temperaturen können durch getrennte Heizwicklungen 11 und 12 in den entsprechenden Bereichen erzeugt werden. Die entsprechenden Temperaturverhältnisse sind in Figur 2 in einem zugeordneten Diagramm in Abhängigkeit von der Ausdehnung x der Heizvorrichtung veran-

4

schaulicht. Wie aus dem Strahlungs-Temperaturprofil des Diagrammes hervorgeht, ist zwischen den beiden Heizbereichen 9 und 10 zwangsläufig eine Übergangszone 14 ausgebildet, in der die Temperatur T von dem Temperaturniveau $T_1$ des Bereichs 9 auf das höheve Temperaturniveau $T_2$ des Bereichs 10 zunimmt. In dieser Zone 14 sollte der maximale positive, d.h. in Bewegungsrichtung zu messende Temperaturgradient $\Delta T/\Delta x$ mindestens 5 K/mm, vorzugsweise mindestens 10 K/mm, insbesondere mindestens 50 K/mm betragen.

Wie ferner in Figur 2 durch gepfeilte Linien angedeutet sein soll, kann in dem Arbeitsbereich 8 eine Atmosphäre insbesondere durch strömendes $O_2$ ausgebildet sein. Die $O_2$-Beladung des Vorproduktes zur Einstellung der exakten $O_2$-Stöchiometrie der gewünschten supraleitenden Hoch-$T_c$-Phase kann jedoch auch in einem sich an die Wärmebehandlung anschließenden Verfahrensschritt erfolgen.

Man bewegt nun das Vorprodukt V durch die Übergangszone 14 mit der vorbestimmten Geschwindigkeit v, die vorteilhaft zwischen 0,1 cm/sec und 10 cm/sec, vorzugsweise zwischen 0,5 cm/sec und 5 cm/sec gewählt wird. Hierbei wandert vorteilhaft über das Vorprodukt in Bewegungsrichtung ein Temperaturgradientenfeld mit dem maximalen Temperaturgradienten der genannten Größe. Unter Einwirkung dieses Gradientenfeldes wird eine Texturierung des Kristallaufbaus in dem Material des Vorproduktes dahingehend gefördert, daß die für die Stromführung entscheidenden Ebenen der Kristalle der auszubildenden supraleitenden Hoch-$T_c$-Phase zumindest weitgehend parallel zur Oberfläche des Substrates bzw. des Vorproduktes zu liegen kommen.

Gemäß dem erläuterten Ausführungsbeispiel wurde davon ausgegangen, daß das Vorprodukt nach dem Abscheiden auf dem Substrat während einer Aufheizphase des Wärmebehandlungsschrittes durch die bereits auf erhöhtem Temperaturniveau befindliche Übergangszone 14 mit dem vorbestimmten Temperaturgradienten $\Delta T/\Delta x$ bewegt wird. Um die gewünschte Förderung einer Ausrichtung der anisotropen Kristallstrukturen in dem Vorprodukt zu bewirken, ist es jedoch gegebenenfalls auch möglich, zunächst in bekannter Weise eine Wärmebehandlung des Vorproduktes vorzunehmen. An diese (erste) Wärmebehandlung kann sich dann die erfindungsgemäße Wärmebehandlung mit dem Temperaturgradienten quasi als thermische Nachbehandlung anschließen. In diesem Falle ist der vor dieser thermischen Nachbehandlung vorliegende Aufbau des beschichteten Substrates definitionsgemäß als Vorprodukt anzusehen.

## Patentansprüche

1. Verfahren zur Herstellung einer Schicht aus einem metalloxidischen Supraleitermaterial mit hoher Sprungtemperatur, bei welchem zunächst eine Schicht eines metalloxidischen Vorproduktes aus den Komponenten des Materials mit einem bezüglich der auszubildenden supraleitenden Metalloxidphase noch fehlstrukturierten Kristallgefüge auf einem Substrat aufgebracht wird und anschließend mittels einer Wärme- und Sauerstoffbehandlung die gewünschte supraleitende Metalloxidphase mit einer zumindest teilweise geordneten Kristallstruktur ausgebildet wird, wobei die Kristallstruktur anisotrop ist und eine kritische Stromdichte der Schicht verursacht, die parallel zur Oberfläche der Schicht größer als in Richtung der Normalen auf der Schicht ist, **dadurch gekennzeichnet,** daß das Vorprodukt (V) mit einer vorbestimmten Geschwindigkeit (v) parallel zur Oberfläche der Schicht (3) durch eine erhitzte Zone (14) bewegt wird, in der ein positiver, in Bewegungsrichtung zu messender maximaler Temperaturgradient ($\Delta T/\Delta x$) von mindestens 5 K/mm ausgebildet ist.

2. Verfahren nach Anspruch 1, **dadurch gekennzeichnet,** daß in der erhitzten Zone (14) ein maximaler Temperaturgradient ($\Delta T/\Delta x$) von mindestens 10 K/mm, vorzugsweise von mindestens 50 K/mm ausgebildet wird.

3. Verfahren nach Anspruch 1 oder 2, **dadurch gekennzeichnet,** daß das Vorprodukt (V) während einer Aufheizphase der Wärmebehandlung durch die erhitzte Zone (14) bewegt wird.

4. Verfahren nach Anspruch 1 oder 2, **dadurch gekennzeichnet,** daß das Vorprodukt (V) nach einer ersten Wärmebehandlung durch die erhitzte Zone (14) bewegt wird.

5. Verfahren nach einem der Ansprüche 1 bis 4, **dadurch gekennzeichnet,** daß in der erhitzten Zone (14) eine sauerstoffhaltige Atmosphäre ausgebildet wird.

6. Verfahren nach Anspruch 5, **dadurch gekennzeichnet,** daß die erhitzte Zone (14) mit reinem Sauerstoff (15) durchströmt wird.

7. Verfahren nach einem der Ansprüche 1 bis 6, **dadurch gekennzeichnet,** daß das Vorprodukt (V) mit einer Geschwindigkeit (v) zwischen 0,1 cm/sec und 10 cm/sec, vorzugsweise zwischen 0,5 cm/sec und 5 cm/sec durch die erhitzte Zone (14) bewegt wird.

8. Verfahren nach einem der Ansprüche 1 bis 7, **dadurch gekennzeichnet,** daß ein metalloxidisches Supraleitermaterial auf Basis des Stoffsystems Me1-Me2-Cu-O hergestellt wird, wobei die Komponenten Me1 ein Seltenes Erdmetall einschließlich Yttrium und Me2 ein Erdalkalimetall zumindest enthalten.

9. Vorrichtung zur Durchführung des Verfahrens nach einem der Ansprüche 1 bis 8, **dadurch gekennzeichnet,** daß eine Heizvorrichtung (7) vorgesehen ist,

– die mindestens zwei hintereinander angeordnete, räumlich voneinander getrennte Heizbereiche (9, 10) mit unterschiedlichen Temperaturniveaux ($T_1$ bzw. $T_2$) zur Ausbildung der erhitzten Zone (14) mit dem maximalen Temperaturgradienten ($\Delta T/\Delta x$) von mindestens 5 K/mm zwischen den mindestens zwei Heizbereichen (9, 10) aufweist, wobei der in Bewegungsrichtung gesehen nachgeordnete Bereich (10) auf dem höheren Temperaturniveau ($T_2$) liegt, und

– die insbesondere eine kontinuierliche Wärmebehandlung von langgestreckten Körpern wie z.B. Leitern ermöglicht, und daß eine Einrichtung zur Bewegung der Schicht (3) des metalloxidischen Vorprodukts (V) durch die erhitzte Zone (14) parallel zur Oberfläche der Schicht (3) mit der vorbestimmten Geschwindigkeit (v) vorgesehen ist.

10. Vorrichtung nach Anspruch 9, **dadurch gekennzeichnet**, daß der Temperaturunterschied zwischen den beiden Heizbereichen (9, 10) mindestens 200°C beträgt.

11. Vorrichtung nach Anspruch 9 oder 10, **dadurch gekennzeichnet,** daß der in Bewegungsrichtung gesehen erste Heizbereich (9) auf einem Temperaturniveau ($T_1$) zwischen 350°C und 550°C, vorzugsweise zwischen 400°C und 500°C liegt.

12. Vorrichtung nach einem der Ansprüche 9 bis 11, **dadurch gekennzeichnet,** daß der nachgeordnete Heizbereich (10) auf einem Temperaturniveau ($T_2$) über 650°C, vorzugsweise über 750°C liegt.

## Claims

Process for the production of a layer of a metal-oxide superconductive material with a high transition temperature, in which first of all a layer of a metal oxide preliminary product from the components of the material, having still a faulty crystal structure with respect to the superconductive metal-oxide phase to be formed, is applied to a substrate and then, by means of a heat and oxygen treatment, the desired superconductive metal oxide phase is formed with an at least partially ordered crystal structure, where the crystal structure is anisotropic and results in a critical current density in the layer which is greater in the direction parallel to the surface of the layer than in the direction normal to the layer, **characterised in that** the preliminary product (V) is moved at a predetermined speed (v) parallel to the surface of the layer (3) through a heated zone (14) in which a positive maximum temperature gradient ($\Delta T/\Delta x$) to be measured in the direction of movement, of at least 5 K/mm is developed.

2. Process according to claim 1, **characterised in that** in the heated zone (14) there is developed a maximum temperature gradient ($\Delta T/\Delta x$) of at least 10 K/mm, preferably of at least 50 K/mm.

3. Process according to claim 1 or 2, **characterised in that** the preliminary product (V) is moved through the heated zone (14) during a heating up phase of the heat treatment.

4. Process according to claim 1 or 2, **characterised in that** the preliminary product (V) is moved through the heated zone (14) after a first heat treatment.

5. Process according to one of claims 1 to 4, **characterised in that** an oxygen-containing atmosphere is formed in the heated zone (14).

6. Process according to claim 5, **characterised in that** the heated zone (14) has pure oxygen (15) flowing through it.

7. Process according to one of claims 1 to 6, **characterised in that** the preliminary product (V) is moved through the heated zone (14) at a speed (v) of between 0.1 cm/sec and 10 cm/sec, preferably between 0.5 cm/sec and 5 cm/sec.

8. Process according to one of claims 1 to 7, **characterised in that** a metal oxide superconductive material based on the material system Me1-Me2-Cu-O is produced wherein the component Me1 contains at least a rare earth metal including yttrium, and Me2 contains at least an alkaline earth metal.

9. Device for carrying out the method according to one of claims 1 to 8, **characterised in that** a heating device (7) is provided

– which has at least two heating zones (9, 10) arranged one behind the other and spatially separated from each other with different temperature levels ($T_1$ or $T_2$) for forming the heated zone (14) with the maximum temperature gradient ($\Delta T/\Delta x$) of at least 5 K/mm between the at least two heating zones (9, 10), whereby the subsequently disposed zone (10) seen in the direction of movement is at the higher temperature level ($T_2$), and

– which makes possible in particular a continuous heat treatment of longitudinally extended bodies, such as e.g. conductors,

and in that a device is provided for moving the layer (3) of the metal oxide preliminary product (V) through

EP 0 330 899 B1

the heated zone (14) parallel to the surface of the layer (3) at the predetermined speed (v).

10. Device according to claim 9, **characterised in that** the temperature difference between the two heating zones (9, 10) is at least 200°C.

11. Device according to claim 9 or 10, **characterised in that** the first heating zone (9) seen in the direction of movement is at a temperature level ($T_1$) between 350 °C and 550 °C, preferably between 400 °C and 500 °C.

12. Device according to one of claims 9 to 11, **characterised in that** the subsequently arranged heating zone (10) is at a temperature level ($T_2$) above 650 °C, preferably above 750 °C.

## Revendications

1. Procédé pour réaliser une couche en un matériau de supraconducteur à oxyde métallique, possédant une température de transition élevée, dans lequel on dépose sur un substrat une couche d'une ébauche à oxyde métallique, constituée par les constituants du matériau présentant, par rapport à la phase oxyde métallique supraconductrice à former, un réseau cristallin à structure encore imparfaite, et on réalise ensuite, à l'aide d'un traitement thermique et à l'oxygène, la phase oxyde métallique supraconductrice souhaitée et à structure cristalline au moins partiellement ordonnée, la structure cristalline étant anisotrope et conduisant à une densité de courant critique de la couche, laquelle densité de courant est plus grande dans le sens parallèle à la surface de la couche que dans la direction de la normale à la couche, **caractérisé par le fait** que l'ébauche (V) est déplacée avec une vitesse prédéterminée (v), parallèlement à la surface de la couche (3), à travers une zone chauffée (14) dans laquelle est formé un gradient de temperature maximum positif ($\Delta T/\Delta x$) à mesurer dans le sens du déplacement et qui est au moins égal à 5 K/mm.

2. Procédé selon la revendication 1, **caractérisé par le fait** que dans la zone chauffée (14), on réalise un gradient de température maximum ($\Delta T/\Delta x$) d'au moins 10 K/mm, de préférence d'au moins 50 K/mm.

3. Procédé selon la revendication 1 ou 2, **caractérisé par le fait** que l'ébauche (V) est déplacée à travers la zone chauffée (14), pendant une phase d'échauffement du traitement thermique.

4. Procédé selon la revendication 1 ou 2, **caractérisé par le fait** que l'ébauche (V) est déplacée, à travers la zone chauffée (14), après un premier traitement thermique.

5. Procédé selon l'une des revendications 1 à 4, **caractérisé par le fait** que l'on forme dans la zone chauffée (14), une atmosphère à teneur en oxygène.

6. Procédé selon la revendication 5, **caractérisé par le fait** que la zone chauffée (14) est traversée par de l'oxygène pur (15).

7. Procédé selon l'une des revendications 1 à 6, **caractérisé par le fait** que l'ébauche (V) est déplacée à travers la zone chauffée (14), à une vitesse (v) se situant entre 0,1 cm/sec et 10 cm/sec, de préférence entre 0,5 cm/sec et 5 cm/sec.

8. Procédé selon l'une des revendications 1 à 7, **caractérisé par le fait** que l'on prépare un matériau supraconducteur oxyde métallique sur la base du système de substances Me1-Me2-Cu-O, les constituants Me1 contenant au moins un métal des terres rares, y compris de l'yttrium, et Me2 contenant un métal alcalino terreux.

9. Dispositif pour la mise en oeuvre du procédé selon l'une des revendications 1 à 8, caractérisé par le fait qu'il est prévu un dispositif de chauffage (7)

– qui comporte au moins deux zones de chauffage (9, 10), disposées l'une derrière l'autre avec séparation spatiale et à niveaux de températures différents ($T_1$, $T_2$) en vue de réaliser la zone chauffée (14) à gradient de température maximum ($\Delta T/\Delta x$) égal à au moins 5 K/mm entre lesdites au moins deux zones de chauffage (9, 10), la zone (10) qui est située en aval, dans la direction du déplacement, se situant au niveau de température le plus élevé ($T_2$),

et

– qui autorise, en particulier, un traitement thermique continu de corps allongés, tels que des conducteurs, par exemple,

et qu'il est prévu un dispositif de déplacement pour la couche (3) de l'ébauche à oxyde métallique (V) à travers la zone chauffée (14), parallèlement à la surface de la couche (3) et à la vitesse prédéterminée (v).

10. Dispositif selon la revendication 9, **caractérisé par le fait** que la différence de température entre les deux zones de chauffage (9, 10) est au moins égale à 200 °C.

11. Dispositif selon la revendication 9 ou 10, **caractérisé par le fait** que la première zone de chauffage, si on regarde dans le sens du déplacement, se situe à un niveau de température ($T_1$) compris entre 350 °C et 550 °C, de préférence entre 400 °C et 500 °C.

7

12. Dispositif selon l'une des revendications 9 à 11, **caractérisé par le fait** que la zone de chauffage aval (10) se trouve au niveau de température ($T_2$) supérieur à 550 °C, de préférence supérieur à 750 °C.

FIG 1

FIG 2